# FASCICULE DE BREVET EUROPEEN

(11) **EP 2 536 260 B1**
(45) Date de publication et mention de la délivrance du brevet: **23.04.2014**
(21) Numéro de dépôt: 12170761.6
(22) Date de dépôt: 04.06.2012
(51) Int. Cl.: H05K 5/00, H04L 12/28

(54) **Passerelle entre un réseau local et un réseau étendu**
Gateway zwichen einem localen Netzwerk und einem globalen Netwerk
Gateway between a local network and a wide area network

(30) Priorité: 14.06.2011 FR 1155178
(43) Date de publication de la demande: 19.12.2012
(73) Titulaire: Orange, 75015 Paris (FR)
(72) Inventeur: Guazzetti, Manuel, 78220 VIROFLAY (FR); Vincent, Yoann, 94230 CACHAN (FR)
(74) Mandataire: Cabinet Plasseraud

(56) Documents cités:
- US-A- 5 838 548
- US-A- 6 059 614
- US-A1- 2002 067 593
- US-A1- 2004 069 518
- US-B1- 6 328 612

## Description

La présente invention concerne une passerelle destinée à être reliée à un réseau local d'une part et à un réseau étendu d'autre part, comprenant un boîtier principal dans lequel sont logés des composants électroniques et des connecteurs pour relier un ou plusieurs équipements du réseau local au boîtier principal.

Le document US 5 838 548 A décrit un dispositif de réseau local comprenant un boîtier principal comportant des composants électroniques et des connecteurs pour la liaison à un ou plusieurs équipements du réseau local, et un boîtier secondaire monté amovible sur le boîtier principal et comportant des composants électroniques et des connecteurs au moins pour la liaison au boîtier principal.

Dans le domaine de la télécommunication de données liées à des services proposés par un opérateur sur un réseau étendu, tel qu'Internet, à des équipements d'un réseau local, les différents types d'équipements connaissent une évolution permanente.

Cette évolution permanente nécessite donc d'adapter en conséquence les passerelles reliant le réseau local au réseau étendu.

L'invention a pour but de proposer une passerelle permettant d'offrir un confort d'utilisation optimal quelle que soit l'évolution des technologies actuelles.

A cet effet, l'invention a pour objet une passerelle selon la revendication 1.

Grâce au boîtier secondaire, la passerelle selon l'invention permet d'offrir à l'utilisateur des fonctionnalités supplémentaires par rapport à celles du boîtier principal.

La passerelle selon l'invention peut comporter une ou plusieurs des caractéristiques suivantes :
- la plaque formant interface est montée de manière coulissante sur le boîtier principal, l'un parmi le boîtier principal et la plaque formant interface comprenant une rainure de guidage et l'autre parmi le boîtier principal et la plaque formant interface comprenant un rail de guidage, la rainure de guidage et le rail de guidage étant adaptés pour coopérer l'un avec l'autre lorsque la plaque formant interface est montée sur le boîtier principal ;
- elle comprend des moyens de blocage adaptés pour bloquer la plaque formant interface en position sur le boîtier principal ;
- la plaque formant interface est montée de manière amovible sur le corps de boîtier;
- la plaque formant interface est montée de manière coulissante sur le corps de boîtier, l'un parmi le corps de boîtier et la plaque formant interface comprenant une rainure de guidage et l'autre parmi le corps de boîtier et la plaque formant interface comprenant un rail de guidage, la rainure de guidage et le rail de guidage étant adaptés pour coopérer l'un avec l'autre lorsque la plaque formant interface est montée sur le corps de boîtier ;
- elle comprend des moyens de blocage adaptés pour bloquer la plaque formant interface en position sur le corps de boîtier ;
- elle comprend un cache monté, en l'absence du boîtier secondaire, de manière amovible sur le boîtier principal en lieu et place du boîtier secondaire ;
- le boîtier principal comprend un peigne formé par une pluralité de dents séparées les unes des autres par des encoches, chaque encoche étant adaptée pour recevoir un câble de connexion ; et
- le boîtier secondaire comprend des connecteurs pour relier un ou plusieurs équipements supplémentaires du réseau local au boîtier secondaire.

L'invention sera mieux comprise à la lecture de la description qui va suivre, donnée uniquement à titre d'exemple et faite en se référant aux dessins annexés, sur lesquels :
- la Figure 1 est une vue schématique de l'environnement d'une passerelle selon l'invention ;
- la Figure 2 est une vue en perspective arrière d'un boîtier principal de la passerelle de la Figure 1 ;
- la Figure 3 est une vue en perspective arrière d'un boîtier secondaire de la passerelle de la Figure 1 ;
- la Figure 4 est une vue latérale d'une plaque formant interface du boîtier secondaire de la Figure 3 ;
- la Figure 5 est une vue en perspective latérale du boîtier principal de la Figure 2 ; et
- les Figures 6A, 6B et 6C sont des vues en perspective avant de différentes passerelles selon l'invention.

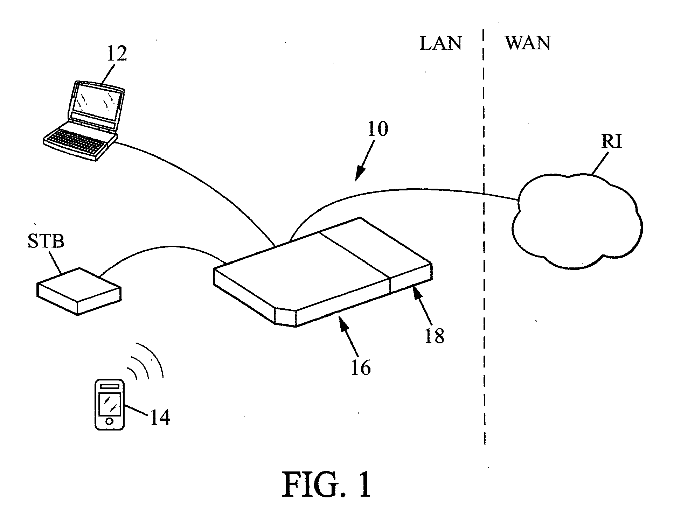

La Figure 1 illustre l'environnement d'une passerelle 10 selon l'invention reliant un réseau local LAN (pour « Local Area Network ») à un réseau étendu WAN (pour « Wide Area Network ») tel qu'Internet par exemple.

Le réseau local LAN comprend un ordinateur 12 pour permettre à un utilisateur d'accéder notamment au réseau Internet RI, un terminal STB de type « Set Top Box » (appelé communément « décodeur TV ») pour permettre à l'utilisateur de recevoir des données de télévision notamment, et un terminal 14 de téléphonie pour permettre à l'utilisateur de transmettre typiquement de la voix sur IP (pour « Internet Protocol »).

La passerelle 10 est un modem-routeur de type « Livebox® » par exemple, commercialisé par la Demanderesse.

La passerelle 10 comprend un boîtier principal 16 et un boîtier secondaire 18 monté de manière amovible sur le boîtier principal 16.

De manière classique, le boîtier principal 16 est adapté pour loger des composants électroniques ainsi que des connecteurs pour relier les différents équipements du réseau local LAN aux composants électroniques du boîtier principal 16, par une liaison filaire ou sans fil (par exemple par une connexion WiFi).

Le boîtier principal 16 présente une forme sensiblement parallélépipédique.

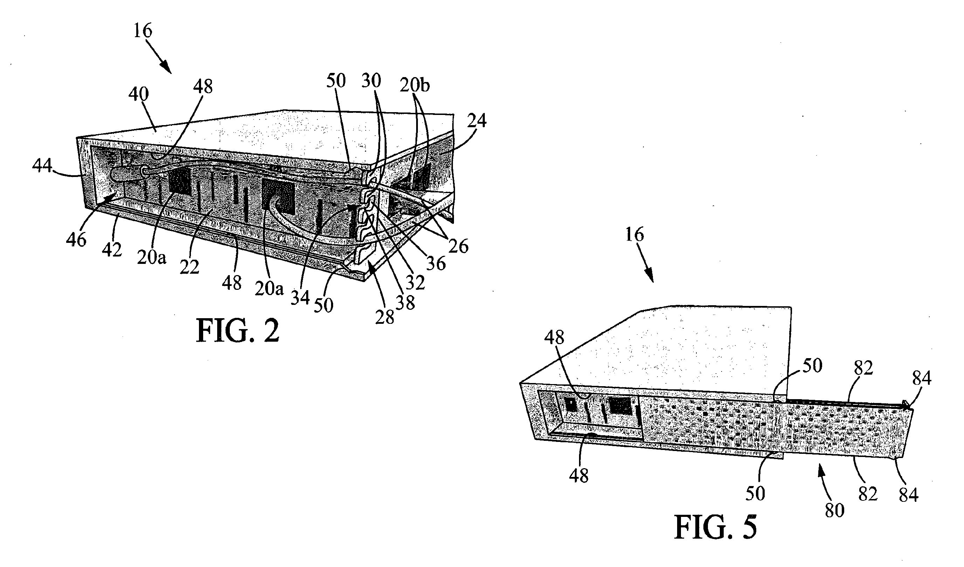

En référence à la Figure 2, des connecteurs 20a sont prévus sur la face latérale droite 22 du boîtier principal 16, et des connecteurs 20b sont prévus sur la face arrière 24 du boîtier principal 16.

Les termes de position et d'orientation utilisés ici, tels que « avant », « arrière », « latéral », « supérieur », « inférieur », « droite », « gauche », etc., s'entendent par rapport à la position de la passerelle 10 illustrée sur la Figure 1.

Afin d'éviter un entremêlement des câbles de connexion 26 reliant des équipements du réseau local LAN aux connecteurs correspondants 20a situés sur la face latérale droite 22, le boîtier principal 16 comprend un peigne 28 formé par une pluralité de dents 30 faisant saillie du bord arrière 32 de la face latérale droite 22 et s'étendant dans le prolongement de la face arrière 24.

Les dents 28 sont séparées les unes des autres par des encoches 34 adaptées chacune pour recevoir et maintenir un câble de connexion 26, chaque encoche 34 présentant un fond 36 de forme sensiblement circulaire s'ouvrant sur l'extérieur du boîtier principal 16 par un rétrécissement 38.

Les parois supérieure 40, inférieure 42 et avant 44 du boîtier principal 16 forment avec la face latérale droite 22 et le peigne 28 un espace 46 de réception des câbles 26.

Le boîtier principal 16 comporte deux rainures de guidage 48 opposées ménagées respectivement sur les parois supérieure 40 et inférieure 42.

Les rainures de guidage 48 s'ouvrent l'une vers l'autre et s'étendent le long du bord droit respectivement des parois supérieure 40 et inférieure 42, depuis la paroi avant 44 pour déboucher vers l'arrière respectivement des parois supérieure 40 et inférieure 42.

Le boîtier principal 16 comprend en outre deux entailles de blocage 50 opposées pratiquées sur le bord droit respectivement des parois supérieure 40 et inférieure 42, à proximité de leur bord arrière respectif.

Le boîtier secondaire 18 est adapté pour loger des composants électroniques ainsi que des connecteurs 52 pour relier un ou plusieurs équipements supplémentaires du réseau local LAN aux composants électroniques du boîtier secondaire 18, par une liaison filaire ou sans fil (par exemple par une connexion WiFi), ainsi que pour relier le boîtier secondaire 18 au boîtier principal 16, par une liaison filaire par exemple de type Giga Ethernet ou sans fil par exemple de type WiFi.

Le boîtier secondaire 18 est également adapté pour offrir à un utilisateur des fonctionnalités supplémentaires par rapport à celles offertes par le boîtier principal 16.

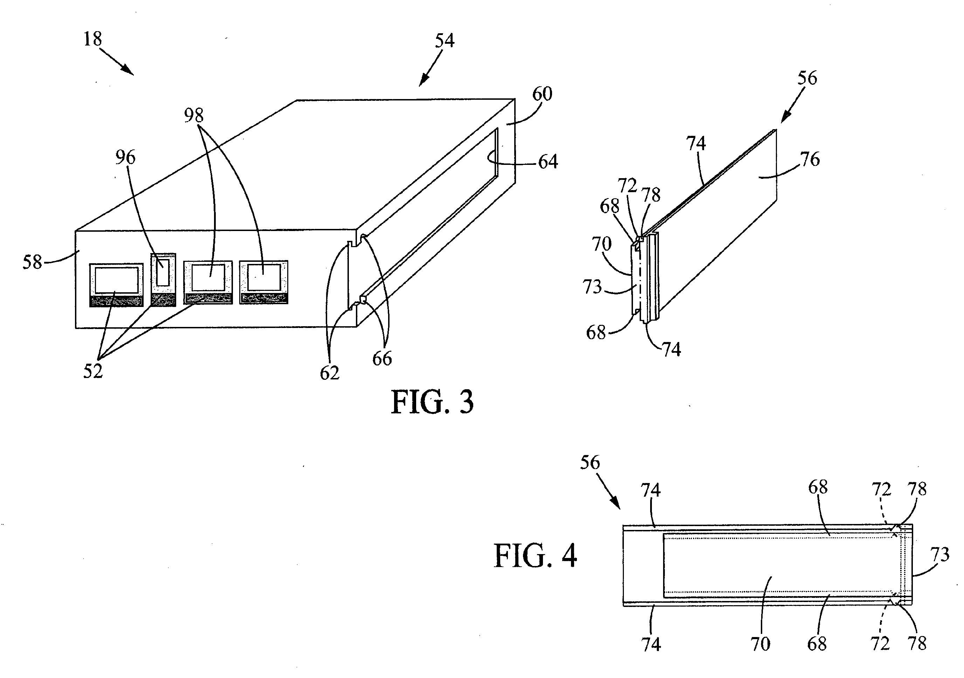

Comme illustré sur la Figure 3, le boîtier secondaire 18 comprend un corps de boîtier 54 et une plaque 56 montée de manière amovible sur le corps de boîtier 54.

Le corps de boîtier 54 présente une forme sensiblement parallélépipédique.

Des connecteurs 52 sont prévus sur la face arrière 58 du corps de boîtier 54.

Le corps de boîtier 54 comporte, sur sa face latérale gauche 60, deux rainures de guidage 62 opposées.

Les rainures de guidage 62 s'ouvrent l'une vers l'autre et s'étendent chacune le long de la face latérale gauche 60 depuis une butée avant 64 adjacente au bord avant de la face latérale gauche 60 pour déboucher sur le bord arrière de la face latérale gauche 60.

Deux entailles de blocage 66 opposées sont pratiquées sur la face latérale gauche 60 à proximité de son bord arrière et au niveau des rainures de guidage 62.

En référence aux Figures 3 et 4, la plaque 56 comporte une paire droite de rails de guidage 68 opposés prévus sur sa face droite 70.

Les rails de guidage 68 possèdent une forme complémentaire de celle des rainures de guidage 62 du corps de boîtier 54 de telle sorte qu'ils sont reçus chacun de manière coulissante dans une rainure de guidage 62 correspondante lorsque la plaque 56 est assemblée sur le corps de boîtier 54.

Deux ergots de blocage 72 opposés sont disposés respectivement sur les bords supérieur et inférieur de la plaque 56, adjacents à son bord arrière 73 et aux rails de guidage 68.

Les ergots de blocage 72 possèdent une forme complémentaire de celle des entailles de blocage 66 du corps de boîtier 54 de manière à bloquer la plaque 56 en position sur le corps de boîtier 54 lorsque la plaque 56 est assemblée sur le corps de boîtier 54.

La plaque 56 est également adaptée pour être montée de manière amovible sur le boîtier principal 16, formant ainsi une interface entre le boîtier secondaire 18 et le boîtier principal 16.

La plaque 56 comporte ainsi une paire gauche de rails de guidage 74 prévus sur sa face gauche 76.

Les rails de guidage 74 possèdent une forme complémentaire de celle des rainures de guidage 48 du boîtier principal 16 de telle sorte qu'ils sont reçus chacun de manière coulissante dans une rainure de guidage 48 correspondante lorsque la plaque 56 est assemblée sur le boîtier principal 16.

La plaque 56 comporte en outre deux ergots de blocage 78 opposés agencés respectivement sur ses bords supérieur et inférieur, adjacents à son bord arrière 73 et aux rails de guidage 74.

Les ergots de blocage 78 possèdent une forme complémentaire de celle des entailles de blocage 50 du boîtier principal 16 de manière à bloquer la plaque 56 en position sur le boîtier principal 16 lorsque la plaque 56 est assemblée sur le boîtier principal 16.

En référence à la Figure 5, la passerelle 10 comprend un cache 80 qui, lorsque le boîtier secondaire 18 n'est pas assemblé sur le boîtier principal 16, peut être monté de manière amovible sur le boîtier principal 16 en lieu et place du boîtier secondaire 18.

Le cache 80 comprend, sur ses bords supérieur et inférieur, des rails de guidage 82 adaptés pour coopérer avec les rainures de guidage 48 du boîtier principal 16 de telle sorte qu'ils sont reçus chacun de manière coulissante dans une rainure de guidage 48 correspondante lorsque le cache 80 est assemblé sur le boîtier principal 16.

Les rails de guidage 82 du cache 80 sont ainsi sensiblement identiques aux rails de guidage 74 de la plaque 56.

Le cache 80 comprend également, sur ses bords supérieur et inférieur et à proximité de son bord arrière, deux ergots de blocage 84 adaptés pour coopérer avec les entailles de blocage 50 du boîtier principal 16 de manière à bloquer le cache 80 en position sur le boîtier principal 16 lorsque le cache 80 est assemblé sur le boîtier principal 16.

Les ergots de blocage 84 du cache 80 sont ainsi sensiblement identiques aux ergots de blocage 78 de la plaque 56.

Le procédé d'assemblage de la passerelle 10 est expliqué ci-dessous.

Initialement, la passerelle 10 comprend uniquement le boîtier principal 16 et le cache 80 monté sur le boîtier principal 16.

Le cache 80 permet de masquer les connecteurs 20a agencés sur la face latérale droite 22 du boîtier principal 16 ainsi que les câbles de connexion 26 raccordés à ces connecteurs 20a, améliorant ainsi l'aspect visuel de la passerelle 10.

Lorsqu'un utilisateur souhaite disposer des fonctionnalités supplémentaires offertes par le boîtier secondaire 18, il fait coulisser le cache 80 vers l'arrière du boîtier principal 16.

Lors de ce mouvement, les ergots de blocage 84 du cache 80 et les entailles de blocage 50 du boîtier principal 16 se déforment légèrement pour se désengager les unes des autres, permettant ainsi la poursuite du coulissement du cache 80 et le retrait total de ce dernier.

L'utilisateur insère ensuite la plaque 56 sur le boîtier principal 16, en lieu et place du cache 80, par coulissement vers l'avant des rails de guidage 74 dans les rainures de guidage 48.

Une fois les ergots de blocage 78 engagés dans les entailles de blocage 50 correspondantes, la plaque 56 est bloquée en position sur le boîtier principal 16.

L'utilisateur fait alors glisser vers l'arrière le corps de boîtier 54 sur la plaque 56 par coulissement des rails de guidage 68 dans les rainures de guidage 62, jusqu'à engagement mutuel des ergots de blocage 72 avec les entailles de blocage 66.

Enfin, l'utilisateur connecte le boîtier secondaire 18 et le boîtier principal 16 l'un à l'autre, notamment par l'intermédiaire d'un câble de connexion par exemple de type Giga Ethernet ou en activant une liaison sans fil.

Le corps de boîtier 54 forme ainsi un module d'extension du boîtier principal 16 permettant d'offrir à l'utilisateur des fonctionnalités supplémentaires par rapport au boîtier principal 16.

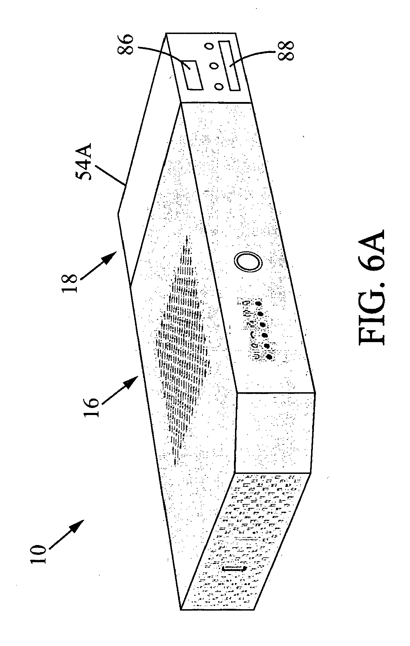

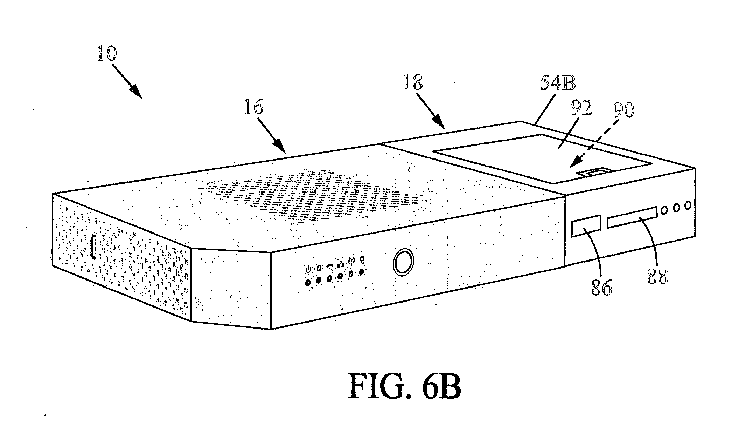

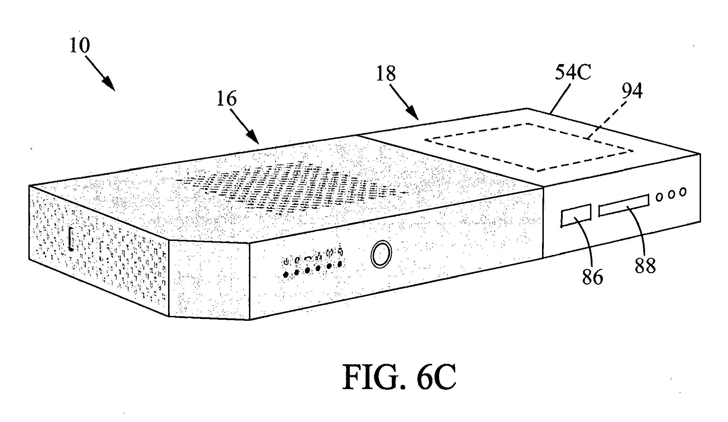

Comme illustré sur les Figures 6A, 6B et 6C, le corps de boîtier peut se décliner sous différentes versions 54A, 54B et 54C ayant chacune des fonctionnalités diverses.

Le point commun des différents corps de boîtier 54A, 54B et 54C est qu'ils comportent tous une face latérale identique à la face latérale 60 du corps de boîtier 54 décrite précédemment pour recevoir de manière amovible la plaque d'interface 56 afin d'être assemblé sur le boîtier principal 16.

Le corps de boîtier 54A de la Figure 6A est un module d'extension fin comportant sur sa paroi avant un connecteur 86 par exemple de type USB 2 et un emplacement 88 destiné à recevoir une carte mémoire de type SD notamment.

Le corps de boîtier 54B de la Figure 6B est un module d'extension présentant en plus sur sa paroi supérieure un logement 90 muni d'un capot 92 et adapté pour recevoir un disque dur nu et pour connecter le disque dur nu aux composants électroniques du corps de boîtier 54B.

Le corps de boîtier 54C de la Figure 6C est un module d'extension intégrant un disque dur 94.

Les corps de boîtier 54A, 54B et 54C comportent, sur leur paroi arrière (Figure 3) un connecteur 96 par exemple de type USB 3 et deux connecteurs 98 par exemple de type Giga Ethernet, un des connecteurs 98 étant par exemple réservé à la connexion avec le boîtier principal 16 dans le cas où une liaison filaire est prévue entre le boîtier principal 16 et le boîtier secondaire 18.

Par ailleurs, la conception du boîtier principal 16 peut varier d'un fabricant à un autre, les différences concernant essentiellement la forme des entailles de blocage 50 et les dimensions et l'agencement des rainures de guidage 48.

Par conséquent, l'invention prévoit des plaques d'interface 56 spécifiques à chaque fabricant qui diffèrent les unes des autres uniquement dans la forme des ergots de blocage 78 et dans les dimensions et l'agencement des rails de guidage 74.

Chaque plaque d'interface comporte ainsi une première face adaptée pour être montée sur le boîtier principal et une deuxième face opposée à la première face et adaptée pour être montée sur le corps de boîtier, les premières faces de différentes plaques d'interface étant différentes les unes des autres par la forme des ergots de blocage et par les dimensions et l'agencement des rails de guidage, les deuxièmes faces de différentes plaques d'interface étant identiques les unes aux autres.

Avantageusement, les différents modules d'extension formés par les différents corps de boîtier sont commercialisés séparément sous forme de packs, chaque pack comprenant un module d'extension et une pluralité de plaques d'interface chacune spécifique à un fabricant particulier.

L'invention propose donc une passerelle entre un réseau local et un réseau étendu permettant d'offrir de nombreuses fonctionnalités à un utilisateur, la passerelle selon l'invention étant en outre modulable au gré des envies de l'utilisateur.

De plus, l'assemblage des différents modules d'extension sur le boîtier principal est très simple et peut être réalisé par l'utilisateur lui-même.

En outre, la passerelle selon l'invention est adaptée aux différentes conceptions propres à chaque fabricant.

Bien entendu, la présente invention ne se limite pas à la forme de réalisation décrite ci-avant à titre d'exemple ; elle s'étend à d'autres variantes.

Ainsi, on comprendra par exemple que le boîtier secondaire 18 peut être monté de manière amovible sur le boîtier principal 16 par tout moyen approprié, notamment par encliquetage.

## Revendications

1. Passerelle (10) destinée à être reliée à un réseau local (LAN) d'une part et à un réseau étendu (WAN) d'autre part, comprenant un boîtier principal (16) dans lequel sont logés des composants électroniques et des connecteurs (20a, 20b) pour relier un ou plusieurs équipements (12, STB, 14) du réseau local (LAN) au boîtier principal (16), un boîtier secondaire (18) dans lequel sont logés des composants électroniques et des connecteurs (52) pour relier au moins le boîtier principal (16) au boîtier secondaire (18), le boîtier secondaire (18) étant monté de manière amovible sur le boîtier principal (16),
**caractérisée en ce que** le boîtier secondaire (18) comprend un corps de boîtier (54) et une plaque (56) formant interface entre le boîtier secondaire (18) et le boîtier principal (16), la plaque formant interface (56) comportant une première face (76) adaptée pour être montée sur le boîtier principal (16) et une deuxième face (70) opposée à la première face (76) et adaptée pour être montée sur le corps de boîtier (54).

2. Passerelle (10) selon la revendication 1, **caractérisée en ce que** la plaque formant interface (56) est montée de manière coulissante sur le boîtier principal (16), l'un parmi le boîtier principal (16) et la plaque formant interface (56) comprenant une rainure de guidage (48) et l'autre parmi le boîtier principal (16) et la plaque formant interface (56) comprenant un rail de guidage (74), la rainure de guidage (48) et le rail de guidage (74) étant adaptés pour coopérer l'un avec l'autre lorsque la plaque formant interface (56) est montée sur le boîtier principal (16).

3. Passerelle (10) selon la revendication 1 ou 2, **caractérisée en ce qu'**elle comprend des moyens de blocage (50, 78) adaptés pour bloquer la plaque formant interface (56) en position sur le boîtier principal (16).

4. Passerelle (10) selon l'une quelconque des revendications 1 à 3, **caractérisée en ce que** la plaque formant interface (56) est montée de manière amovible sur le corps de boîtier (54).

5. Passerelle (10) selon la revendication 4, **caractérisée en ce que** la plaque formant interface (56) est montée de manière coulissante sur le corps de boîtier (54), l'un parmi le corps de boîtier (54) et la plaque formant interface (56) comprenant une rainure de guidage (62) et l'autre parmi le corps de boîtier (54) et la plaque formant interface (56) comprenant un rail de guidage (68), la rainure de guidage (62) et le rail de guidage (68) étant adaptés pour coopérer l'un avec l'autre lorsque la plaque formant interface (56) est montée sur le corps de boîtier (54).

6. Passerelle (10) selon l'une quelconque des revendications 1 à 5, **caractérisée en ce qu'**elle comprend des moyens de blocage (66, 72) adaptés pour bloquer la plaque formant interface (56) en position sur le corps de boîtier (54).

7. Passerelle (10) selon l'une quelconque des revendications 1 à 6, **caractérisée en ce qu'**elle comprend un cache (80) monté, en l'absence du boîtier secondaire (18), de manière amovible sur le boîtier principal (16) en lieu et place du boîtier secondaire (18).

8. Passerelle (10) selon l'une quelconque des revendications 1 à 7, **caractérisée en ce que** le boîtier principal (16) comprend un peigne (28) formé par une pluralité de dents (30) séparées les unes des autres par des encoches (34), chaque encoche (34) étant adaptée pour recevoir un câble de connexion (26).

9. Passerelle (10) selon l'une quelconque des revendications 1 à 8, **caractérisée en ce que** le boîtier secondaire (18) comprend des connecteurs (52) pour relier un ou plusieurs équipements supplémentaires du réseau local (LAN) au boîtier secondaire (18).

## Patentansprüche

1. Gateway (10), das dazu bestimmt ist, einerseits mit einem lokalen Netz (LAN) und andererseits mit einem Weitbereichsnetz (WAN) verbunden zu werden, und das ein Hauptgehäuse (16), in dem elektronische Komponenten und Verbinder (20a, 20b) zum Verbinden eines oder mehrerer Geräte (12, STB, 14) des lokalen Netzes (LAN) mit dem Hauptgehäuse (16) untergebracht sind, und ein sekundäres Gehäuse (18), in dem elektronische Komponenten und Verbinder (52) zum Verbinden wenigstens des Hauptgehäuses (16) mit dem sekundären Gehäuse (18) untergebracht sind, umfasst, wobei das sekundäre Gehäuse (18) abnehmbar an dem Hauptgehäuse (16) montiert ist,
**dadurch gekennzeichnet, dass** das sekundäre Gehäuse (18) einen Gehäusekörper (54) und eine Platte (56), die eine Schnittstelle zwischen dem sekundären Gehäuse (18) und dem Hauptgehäuse (16) bildet, umfasst, wobei die eine Schnittstelle bildende Platte (56) eine erste Fläche (76), die dafür ausgelegt ist, an dem Hauptgehäuse (16) montiert zu werden, und eine zweite Fläche (70) gegenüber der ersten Fläche (76), die dafür ausgelegt ist, an dem Gehäusekörper (54) montiert zu werden, umfasst.

2. Gateway (10) nach Anspruch 1, **dadurch gekennzeichnet, dass** die eine Schnittstelle bildende Platte (56) an dem Hauptgehäuse (16) gleitend montiert ist, wobei entweder das Hauptgehäuse (16) oder die eine Schnittstelle bildende Platte (56) eine Führungsrille (58) aufweist und das bzw. die jeweils andere des Hauptgehäuses (16) und der eine Schnittstelle bildende Platte (56) eine Führungsschiene (54) aufweist, wobei die Führungsrille (48) und die Führungsschiene (74) dafür ausgelegt sind, miteinander zusammenzuwirken, wenn die eine Schnittstelle bildende Platte (56) an dem Hauptgehäuse (16) montiert ist.

3. Gateway (10) nach Anspruch 1 oder 2, **dadurch gekennzeichnet, dass** es Blockiermittel (50, 78) umfasst, die dafür ausgelegt sind, die eine Schnittstelle bildende Platte (56) an ihrer Position am Hauptgehäuse (16) zu blockieren.

4. Gateway (10) nach einem der Ansprüche 1 bis 3, **dadurch gekennzeichnet, dass** die eine Schnittstelle bildende Platte (56) an dem Hauptkörper (54) abnehmbar montiert ist.

5. Gateway (10) nach Anspruch 4, **dadurch gekennzeichnet, dass** die eine Schnittstelle bildende Platte (56) an dem Gehäusekörper (54) gleitend montiert ist, wobei entweder der Gehäusekörper (54) oder die eine Schnittstelle bildende Platte (56) eine Führungsrille (62) aufweist und der bzw. die andere des Gehäusekörpers (54) und der eine Schnittstelle bildenden Platte (56) eine Führungsschiene (68) aufweist, wobei die Führungsrille (62) und die Führungsschiene (68) dafür ausgelegt sind, miteinander zusammenzuwirken, wenn die eine Schnittstelle bildende Platte (56) an dem Gehäusekörper (54) montiert ist.

6. Gateway (10) nach einem der Ansprüche 1 bis 5, **dadurch gekennzeichnet, dass** es Blockiermittel (66, 72) umfasst, die dafür ausgelegt sind, die eine Schnittstelle bildende Platte (56) an ihrer Position an dem Gehäusekörper (54) zu blockieren.

7. Gateway (10) nach einem der Ansprüche 1 bis 6, **dadurch gekennzeichnet, dass** es eine Abdeckung (80) umfasst, die dann, wenn das sekundäre Gehäuse (18) nicht an dem Hauptgehäuse (16) vorhanden ist, statt des sekundären Gehäuses (18) und an dessen Ort abnehmbar montiert ist.

8. Gateway (10) nach einem der Ansprüche 1 bis 7, **dadurch gekennzeichnet, dass** das Hauptgehäuse (16) einen Kamm (28) aufweist, der durch mehrere Zähne (30), die durch Kerben (34) voneinander getrennt sind, gebildet ist, wobei jede Kerbe (34) dafür ausgelegt ist, ein Anschlusskabel (26) aufzunehmen.

9. Gateway (10) nach einem der Ansprüche 1 bis 8, **dadurch gekennzeichnet, dass** das sekundäre Gehäuse (18) Verbinder (52) aufweist, um ein oder mehrere Zusatzgeräte des lokalen Netzes (LAN) mit dem sekundären Gehäuse (18) zu verbinden.

## Claims

1. Gateway (10) intended to be connected to a local area network (LAN) on the one hand and to a wide area network (WAN) on the other hand, comprising a main housing (16) in which are accommodated electronic components and connectors (20a, 20b) for connecting one or more devices (12, STB, 14) from the local area network (LAN) to the main housing (16), a secondary housing (18) in which are accommodated electronic components and connectors (52) for connecting at least the main housing (16) to the secondary housing (18), the secondary housing (18) being mounted removably on the main housing (16),
**characterized in that** the secondary housing (18) comprises a housing body (54) and a plate (56) forming an interface between the secondary housing (18) and the main housing (16), the interface-forming plate (56) including a first face (76) adapted to be mounted on the main housing (16) and a second face (70) opposite the first face (76) and adapted to be mounted on the housing body (54).

2. Gateway (10) according to Claim 1, **characterized in that** the interface-forming plate (56) is mounted slideably on the main housing (16), one among the main housing (16) and the interface-forming plate (56) comprising a guide slot (48) and the other among the main housing (16) and the interface-forming plate (56) comprising a guide rail (74), the guide slot (48) and the guide rail (74) being adapted to cooperate with each other when the interface-forming plate (56) is mounted on the main housing (16).

3. Gateway (10) according to Claim 1 or 2, **characterized in that** it comprises locking means (50, 78) adapted to lock the interface-forming plate (56) in position on the main housing (16).

4. Gateway (10) according to any one of Claims 1 to 3, **characterized in that** the interface-forming plate (56) is mounted removably on the housing body (54).

5. Gateway (10) according to Claim 4, **characterized in that** the interface-forming plate (56) is mounted slideably on the housing body (54), one among the housing body (54) and the interface-forming plate (56) comprising a guide slot (62) and the other among the housing body (54) and the interface-forming plate (56) comprising a guide rail (68), the guide slot (62) and the guide rail (68) being adapted to cooperate with each other when the interface-forming plate (56) is mounted on the housing body (54).

6. Gateway (10) according to any one of Claims 1 to 5, **characterized in that** it comprises locking means (66, 72) adapted to lock the interface-forming plate (56) in position on the housing body (54).

7. Gateway (10) according to any one of Claims 1 to 6, **characterized in that** it comprises a shroud (80) mounted, in the absence of the secondary housing (18), removably on the main housing (16) instead and in place of the secondary housing (18).

8. Gateway (10) according to any one of Claims 1 to 7, **characterized in that** the main housing (16) comprises a comb (28) formed by a plurality of teeth (30) mutually separated by notches (34), each notch (34) being adapted to receive a connection cable (26).

9. Gateway (10) according to any one of Claims 1 to 8, **characterized in that** the secondary housing (18) comprises connectors (52) for connecting one or more additional devices of the local area network (LAN) to the secondary housing (18).
